Europäisches Patentamt

European Patent Office

Office européen des brevets

(19)

(11) Veröffentlichungsnummer: **0 213 436**
**B1**

(12) # EUROPÄISCHE PATENTSCHRIFT

(45) Veröffentlichungstag der Patentschrift:
31.10.90

(51) Int. Cl.⁵: **G01N 24/08, G01R 33/48**

(21) Anmeldenummer: 86110813.2

(22) Anmeldetag: 05.08.86

(54) Verfahren zum Betrieb eines Kernspinresonanzgerätes.

(30) Priorität: 19.08.85 DE 3529629
11.03.86 DE 3608054

(43) Veröffentlichungstag der Anmeldung:
11.03.87 Patentblatt 87/11

(45) Bekanntmachung des Hinweises auf die Patenterteilung:
31.10.90 Patentblatt 90/44

(84) Benannte Vertragsstaaten:
DE FR GB NL

(73) Patentinhaber: Siemens Aktiengesellschaft,
Wittelsbacherplatz 2, D-8000 München 2(DE)

(72) Erfinder: Oppelt, Arnulf, Dr., Schwedenstrasse 25,
D-8521 Spardorf(DE)
Erfinder: Graumann, Rainer, Dr.,
Lucas-Cranach-Strasse 39, D-8552 Höchstadt(DE)

(56) Entgegenhaltungen:
EP-A- 0 135 847
GB-A- 1 596 160
GB-A- 2 048 490
US-A- 4 509 011

REVIEW OF SCIENTIFIC INSTRUMENTS, Band 53, Nr. 9,
Seiten 1319-1337, American Institute of Physics, New
York, US; P.A. BOTTOMLEY: "NMR imaging techniques
and applications: A review"
PATENTS ABSTRACTS OF JAPAN, Band 9,
Nr. 151 (P-367)[1874], 26. Juni 1985; &
JP-A-60 29685 (YOKOKAWA HOKUSHIN DENKI
K.K.) 15.02.1985
PROCEEDINGS OF THE IEEE, Band 71, Nr. 3, März 1983,
Seiten 338-350, IEEE, New York, US; W.S. HINSHAW et

## Beschreibung

Die Erfindung betrifft ein Verfahren zum Betrieb eines Kernspinresonanzgerätes zur Untersuchung eines Objektes mit Hilfe der kernmagnetischen Resonanz, mit Spulen zum Anlegen von magnetischen Grund-und Gradientenfeldern an das Untersuchungsobjekt und einer Hochfrequenzeinrichtung, die das Untersuchungsobjekt mit einer Folge von Hochfrequenzpulsen bestrahlt und die von dem Untersuchungsobjekt abgestrahlten Kernresonanzsignale erfaßt.

Ein Kernspinresonanzgerät dieser Art ist z.B. in der deutschen Patentanmeldung P 31 35 335.5 beschrieben.

Für die Anwendung der Kernspinresonanzgeräte sind bisher verschiedene Betriebsarten entwickelt worden, die sich durch unterschiedliche zeitliche Abfolgen der Hochfrequenzpulse und Gradientenfelder auszeichnen. Die Anwendung einer bestimmten Betriebsart richtet sich im wesentlichen nach der gewünschten Bildinformation. Es seien beispielsweise das Spin-Echo-Verfahren (bezüglich $T_1$ und $T_2$ gemischt betonte Bildgebung), das Inversion Recovery-Verfahren ($T_1$ betonte Bildgebung), sowie die Mehrschichtverfahren und Multiecho-Verfahren genannt. Allgemein ist man bestrebt, für kurze Meßzeiten viel Bildinformation bei hohem Signal-Rausch-Verhältnis zu erhalten. Abbildungsverfahren, die mit SSFP (steady state free precession) arbeiten, sind bekannt geworden als MSP-Verfahren (multiple sensitive point), beschrieben in "Phys. Med. Biol. 22, No. 5 (1977), Seiten 971 bis 974". Sie haben sich aber nicht durchgesetzt, weil sie mit modulierten Gradienten arbeiten, wodurch nur eine unpräzise Schichtauswahl zu erzielen ist. Auch kann die Meßzeit nicht verringert werden, weil nur durch Mittelwertbildung überhaupt eine Schichtauswahl möglich ist.

Aus der EP-A 0 135 847 ist eine Pulssequenz bekannt, bei der zunächst Kernspins einer Schicht durch einen Hochfrequenzpuls mit einem Flip-Winkel von < 90° unter der Einwirkung eines Gradienten angeregt werden. Anschließend wird mehrfach eine Pulsfolge, bestehend aus einem 180°-Puls und einem Read-out-Gradienten, eingeschaltet. Dadurch wird das Spinsystem in den Zustand der "driven free precession" gebracht. Aus den unter den Read-out-Gradienten gewonnenen Signalen kann nach dem Rückprojektionsverfahren oder nach dem 2D-Fouriertransformationsverfahren ein Bild erstellt werden. Dieses Verfahren zielt im wesentlichen auf die Verbesserung des Signal-Rausch-Verhältnisses und ermöglicht keine Verringerung der Meßzeit.

In der Literaturstelle P.A. Bottomley: "NMR Imaging Techniques and Applications: A Review" ist u.a. das sogenannte Spin-Warp-Verfahren beschrieben, bei dem nach einem selektiven 90°-HF-Puls ein Phasenkodiergradient folgt und unter einem Auslesegradienten ein Echo ausgelesen wird. Dieses Verfahren hat sich zwar in der Praxis bewährt, es ist jedoch relativ langsam, da die Repetitionszeit hierbei nicht kürzer als die $T_1$-Zeit werden darf. Bei diesem Verfahren stellt sich keine dynamische Gleichgewichtsmagnetisierung ein.

Der Erfindung liegt die Aufgabe zugrunde, ein Verfahren zum Betrieb eines Kernspinresonanzgerätes zu entwickeln, welches mit dynamischer Gleichgewichtsmagnetisierung des Spinsystems arbeitet, die dem MSP-Verfahren anhaftenden Nachteile relativ unpräziser Schichtauswahl und Mittelwertbildung vermeidet und die gewünschte Bildinformation in kürzerer Meßzeit gewinnt.

Lösungen dieser Aufgabe sind in den Ansprüchen 1 bis 3 angegeben. Dabei wird jeweils die dynamische Gleichgewichtsmagnetisierung mit Hilfe geschalteter, unmodulierter Gradientenfelder sowie einer Hochfrequenz-Pulsfolge von hoher Symmetrie aufrechterhalten.

Die Kernmomente werden durch eine Folge von Hochfrequenzimpulsen und Gradientenfeldern in einen dynamischen Gleichgewichtszustand versetzt, dem eine quasi permanente hohe Quermagnetisierung eigen ist. Damit der dynamische Gleichgewichtszustand aufrechterhalten bleibt, muß die HF- und Gradientenpulsfolge von hoher Symmetrie sein. Für das Signal eines Pixels ergibt sich (Journal of Applied Physics 47, No. 8 (1976), Seite 3709):

$$S \approx \frac{\zeta \sin \alpha}{1 + T_1/T_2 + (1 - T_1/T_2) \cos \alpha}$$

$\zeta$ = Spindichte
$T_1$ = Längsrelaxationszeit
$T_2$ = Querrelaxationszeit
$\alpha$ = Flipwinkel der HF-Impulse

Die mit dem hier vorgeschlagenen Verfahren erreichbare Signalhöhe liegt je nach Verhältnis der Relaxationszeiten $T_1/T_2$ um den Faktor 4 bis 6 mal höher als mit dem bisher gebräuchlichen Abbildungsverfahren bei gleicher Meßzeit. Die Flipwinkel der HF-Pulse sollten in Abhängigkeit vom mittleren Verhältnis $<T_1/T_2>$ derart eingestellt werden, daß

$$\alpha_{opt} = \arccos \frac{\langle T_1/T_2 \rangle - 1}{\langle T_1/T_2 \rangle + 1}$$

ist. Der Signalgewinn kann so gegenüber einen Flipwinkel von $\alpha = 90°$ maximal etwa 20 bis 30 % betragen.

Die Erfindung ist nachfolgend anhand einiger Ausführungsbeispiele sowie der Zeichnung näher erläutert. Es zeigen:

Fig. 1 den Aufbau eines Kernspintomographiegerätes,

Fig. 2 eine Folge der Hochfrequenzpulse und geschalteten Gradienten gemäß einer Ausführungsform der Erfindung bei Anwendung des Projektion-Rekonstruktion-Verfahrens,

Fig. 3 eine Folge der Hochfrequenzpulse und geschalteten Gradienten gemäß einer Ausführungsform der Erfindung bei Anwendung des 2D-Fourier-Rekonstruktions-Verfahrens, und

Fig. 4 eine Folge der Hochfrequenzpulse und geschalteten Gradienten gemäß einer Ausführungsform der Erfindung bei Mehrschichtaufnahmen.

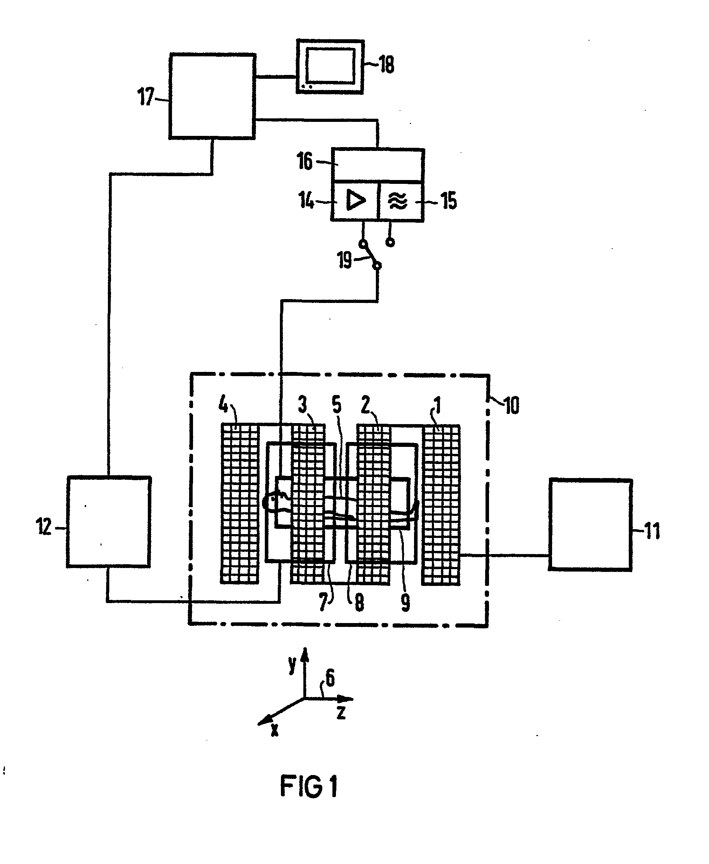

Die Figur 1 zeigt schematisch den prinzipiellen Aufbau eines Kernspintomographiegerätes für die Erstellung von Schnittbildern eines Untersuchungsobjektes. Mit 1 und 2 sowie 3 und 4 sind Spulen gekennzeichnet, die ein magnetisches Grundfeld $B_0$ erzeugen, in welchem sich bei Anwendung zur medizinischen Diagnostik der zu untersuchende Körper 5 eines Patienten befindet. Diesem sind außerdem Gradientenspulen zugeordnet, die zur Erzeugung unabhängiger, zueinander senkrechter Magnetfeldgradienten der Richtungen x, y und z gemäß der Andeutung in 6 vorgesehen sind. In der Figur sind der Übersichtlichkeit halber nur die Gradientenspulen 7 und 8 gezeichnet, die zusammen mit einem Paar gegenüberliegender, gleichartiger Gradientenspulen zur Erzeugung des x-Gradienten dienen. Die gleichartigen, nicht gezeichneten y-Gradientenspulen liegen parallen zum Körper 5 und oberhalb sowie unterhalb von ihm; die für das z-Gradientenfeld quer zu seiner Längsachse am Kopf und am Fußende. Die Anordnung enthält außerdem noch eine zur Erzeugung und Aufnahme der Kernresonanzsignale dienende Hochfrequenzspule 9. Die von einer strichpunktierten Linie 10 umgrenzten Spulen 1, 2, 3, 4, 7, 8 und 9 stellen das eigentliche Untersuchungsinstrument dar. Es wird von einer elektrischen Anordnung aus betrieben, die ein Netzgerät 11 zum Betrieb der Spulen 1 bis 4 sowie eine Gradientenstromversorgung 12, an welcher die Gradientenspulen 7 und 8 sowie die weiteren Gradientenspulen liegen, umfaßt. Die Meßspule 9 ist über einen Signalverstärker 14 bzw. einen Hochfrequenzsender 15 an einen Prozeßrechner 17 gekoppelt, an dem zur Ausgabe der Abbildung ein Bildschirmgerät 18 angeschlossen ist. Die Komponenten 14 und 15 bilden eine Hochfrequenzeinrichtung 16 zur Signalerzeugung und -aufnahme. Ein Umschalter 19 ermöglicht das Umschalten von Sende- auf Empfangsbetrieb.

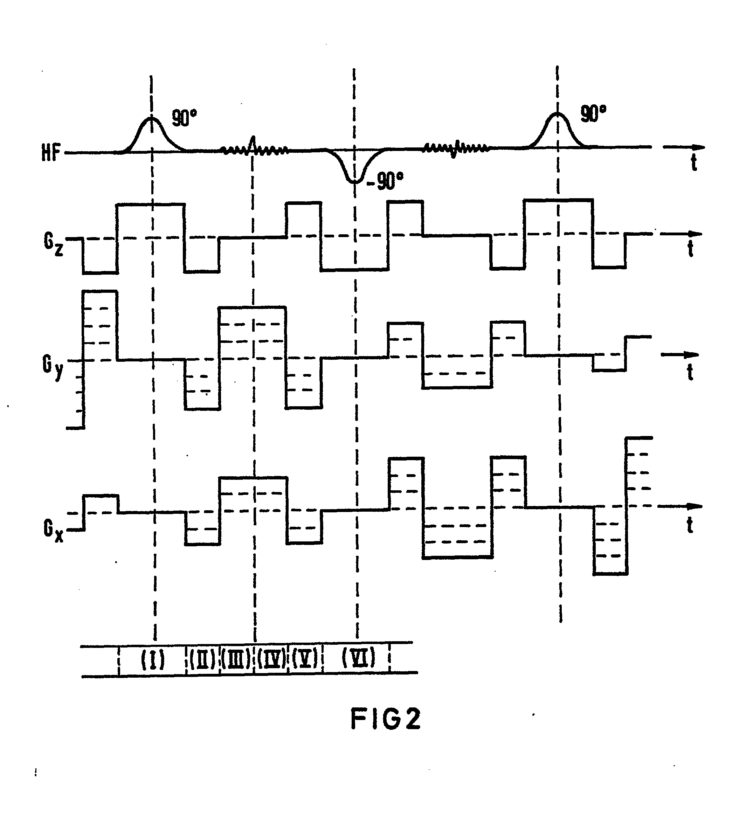

Eine mögliche Ausführungsform des erfindungsgemäßen Betriebsverfahrens ist in Figur 2 dargestellt, die die in der Hochfrequenzeinrichtung 15 und Gradientenschalteinrichtung 12 erzeugten Pulsfolgen zeigt. Zu einem Scan gehören alle Pulse, die zum Messen einer Zeile im Fourierraum und zum Wiederherstellen des Spinzustandes vor dem Scan nötig sind. Er beginnt in diesem Beispiel mit einer Anregung der Kerne (I) durch einen selektiven Hochfrequenzpuls (Schichtauswahlgradient $G_z$ eingeschaltet) mit einem Flipwinkel $\alpha$ (0° kleiner $\alpha$ kleiner gleich 90°). Sodann erfolgt im Zeitabschnitt (II) eine Dephasierung der Kernmagnetisierung bezüglich einer bestimmten Raumrichtung durch Anschalten eines Projektionsgradienten $-G_r$ mit den Vektorkomponenten $-G_x$ und $-G_y$. Er ist etwa halb. so lang geschaltet, wie während der Hochfrequenzanregung. Danach wird in den Zeitabschnitten (III) und (IV) der Projektionsgradient umgepolt eingeschaltet ($G_r$) und damit die Rephasierung der Spinmomente eingeleitet. Gleichzeitig wird während dieser Schaltzeit (III, IV) das von der angeregten Schicht abgestrahlte Kernresonanzsignal ausgelesen. Der Projektionsgradient $G_r$ bleibt dabei doppelt so lange als zuvor eingeschaltet. Die im Zeitabschnitt (IV) bewirkte Dephasierung wird durch einen sich anschließenden, erneut umgepolten Projektionsgradienten $-G_r$ in eine Rephasierung umgekehrt (V). In den Zeitabschnitten (II) und (V) wird zusätzlich der Schichtauswahlgradient angeschaltet:

$-G_z$ bei (II),

$+G_z$ bei (V).

Durch ihn sollen die während des Anregungspulses (I) auftretenden Dephasierungsvorgänge innerhalb der Schichtdicke bezüglich der z-Richtung korrigiert werden. Da diese Prozesse nicht durch die Schaltzeiten des Projektionsgradienten beeinflußt werden, können die Schaltzeiten für den Projektions- und Schichtauswahlgradienten zusammengelegt werde. Ein Hochfrequenzpuls mit Flip-Winkel $-\alpha$ (0° kleiner $\alpha$ kleiner gleich 90°) bei negativ geschaltetem Schichtauswahlgradienten leitet den nächsten Scan ein (VI). Bei ihm erfolgen dieselben Prozeduren wie beim vorangegangenen Scan, jedoch mit umgekehrten Vorzeichen des Schichtauswahlgradienten und einem veränderten Wert des Projektionsgradienten. Das ganze Verfahren wird fortgeführt, bis sich der Projektionsgradient um 180° gedreht hat.

Bei einer üblichen Gradientenstärke von 3 mT/m dauert der Hochfrequenzpuls etwa 5 msec, die Auslesezeit etwa 5 msec und die beiden Zeitintervalle (II) und (V) zusammen ebenfalls etwa 5 msec. Man erhält also alle 15 msec eine Projektion. Bei 180 Projektionen sind Meßzeiten von 2,7 sec erreichbar. Es mag erforderlich sein, vor Beginn der eigentlichen Datenaufnahme einige Leerprojektionen aufzunehmen, um den dynamischen Gleichgewichtszustand einzustellen. Die Bildrekonstruktion erfolgt nach den bekannten Methoden der gefilterten Rückprojektion.

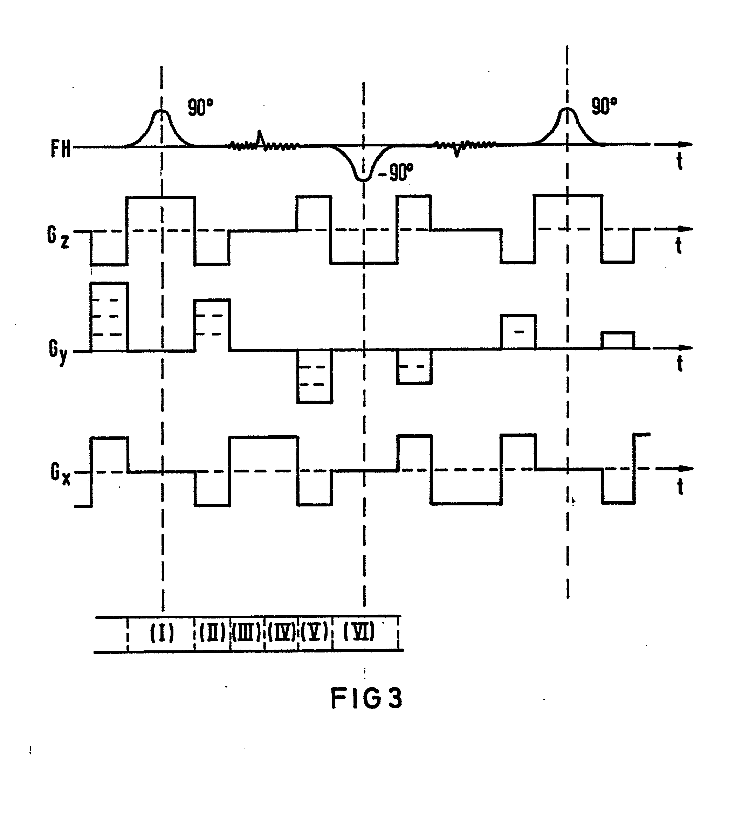

Die Figur 3 zeigt eine Sequenz gemäß der Erfindung, welche bei Anwendung des 2D-Fourierrekonstruktionsverfahrens benutzt werden kann. Bei diesem Verfahren wird bekanntlich das Kernresonanzsignal stets bei Anliegen nur eines Gradientenfeldes (z.B. x-Gradient) ausgelesen. Er wird deswegen als Auslesegradient bezeichnet. Die Ortsinformation des Signales bezüglich der anderen Raumrichtung (also y) wird durch Einprägen eines von Scan zu Scan verschiedenen Phasenganges mit Hilfe eines variablen y-Gradienten (Phasenkodiergradient) erreicht. Auch hier zeichnet sich die Puls- und Gradientenfolge durch eine hohe Symmetrie aus.

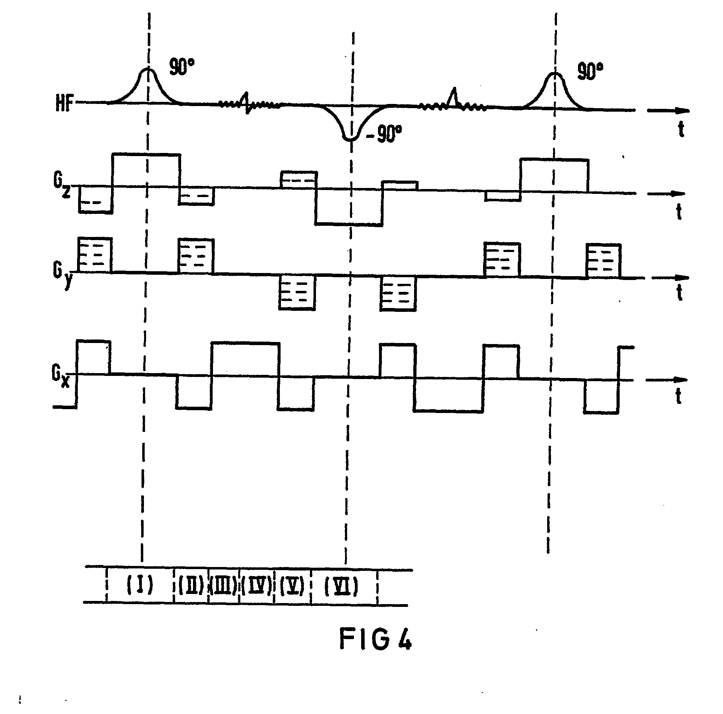

Eine weitere Variante zur Erstellung von Mehrschichtaufnahmen zeigt die Figur 4. Bei dieser Ausführungsform wird mit Hilfe eines von Scan zu Scan sukzessiv veränderten zusätzlichen Schichtgradienten während des Zeitabschnittes (II) den präzedierenden Kernspins ein Phasengang in Abhängigkeit von der z-Koordinate eingeprägt. Hierdurch läßt sich die angeregt Schicht bei der anschließenden 3D-Fourierrekonstruktion in $N_z$ Unterschichten auflösen (bei $N_z$ Schaltstufen für $G_z$).

Bei nicht idealen Verhältnissen in einem zur Aufnahme nach den beschriebenen Verfahren verwendeten Kernspinresonanzgerät kann es in manchen Fällen günstig sein, von der geforderten hohen Symmetrie der Hochfrequenz- und Gradientenpulsfolgen abzuweichen:

a) Werden z.B. durch das alternierende Schalten des Schichtauswahlgradienten unterschiedliche Wirbelströme für positive und negative Amplituden erzeugt, so kann sich dies im Falle der Benutzung des 2D-Rekonstruktionsverfahrens in einer Zeilenstruktur der aufgenommenen Daten im Fourierraum äußern (gerade und ungerade Zeilen erscheinen mit unterschiedlicher Intensität). Um die (bedingt durch die Zeilenstruktur) nach der Bildrekonstruktion auftretenden Mehrfachbilder zu unterdrücken, kann die Sequenz so abgeändert werden, daß der Schichtauswahlgradient für alle Fourierzeilen (Scans) das gleiche Schaltverhalten aufweist.

b) Streifenstrukturen in den Daten des aufgenommenen Fourierraumes, die aufgrund der Interferenz zweier in Ausleserichtung verschobener Echozentren auftreten, lassen sich dadurch beheben, daß die Zentren durch geeignete Justierung der Vordephasierung des Projektions- bzw. Auslesegradienten (Änderung des Zeitintegrals im Zeitabschnitt (II) zur Deckung gebracht werden.

c) In manchen Fällen kann es von Vorteil sein, im Zeitintervall (V) den Schichtauswahlgradienten und/oder den Projektions- bzw. Auslesegradienten nicht einzuschalten. Die sich durch Fehlen dieser Gradientenpulse einstellende Verschiebung des dynamischen Gleichgewichtszustandes kann eine geringere Bildbeeinträchtigung zur Folge haben, als die eventuell durch das Schalten dieser Gradienten auftretenden Störfaktoren.

d) Eventuell vorhandene Inhomogenitäten des Grundfeldes verschieben das dynamische Gleichgewicht in der Weise, daß zur Aufrechterhaltung dieses Gleichgewichtes nicht notwendigerweise ein vorzeichenalternierender Flipwinkel des Hochfrequenzpulses erforderlich ist. Eine entsprechende Pulsfolge mit stets gleichen Vorzeichen des Flipwinkels zeigt demgemäß keinen großen Signalverlust.

**Patentansprüche**

1. Verfahren zum Betrieb eines Kernspinresonanzgerätes zur Untersuchung eines Objektes (5) mit Hilfe der kernmagnetischen Resonanz, mit Spulen (1, 2, 3, 4, 7, 8) zum Anlegen von magnetischen Grund- und Gradientenfeldern an das Untersuchungsobjekt (5), und einer Hochfrequenzeinrichtung (9, 16), die das Untersuchungsobjekt (5) mit einer Folge von Hochfrequenzpulsen bestrahlt und die vom Untersuchungsobjekt (5) ausgesandten Kernresonanzsignale erfaßt, wobei die Bildrekonstruktion mit gefilterter Rückprojektion erfolgt und die dynamische Gleichgewichtsmagnetisierung mit Hilfe geschalteter, unmodulierter Gradientenfelder durch nachstehende Folge aufrecht erhalten wird:

(a) Selektive Anregung einer Schicht des Untersuchungsobjektes durch gleichzeitiges Anlegen eines Schichtauswahlgradienten $G_z$ für eine Dauer T und eines Hochfrequenzpulses mit Flip-Winkel $\alpha$ ($0° < \alpha \leq 90°$).

(b) Gleichzeitiges Anlegen eines Projektionsgradienten $-G_r$ und Schichtauswahlgradienten $-G_z$ für die Dauer von ungefähr T/2.

(c) Anlegen eines Projektionsgradienten $G_r$ und Auslesen des vom Untersuchungsobjekt ausgesandten Kernresonanzsignales für die Dauer von ungefähr T.

(d) –

(e) $N_r$-malige Wiederholung der Folge (a) bis (d), jedoch mit veränderten Richtungen des Projektionsgradienten, bis $N_r$ Scans aufgenommen sind, aus denen sich durch Fouriertransformation und gefilterte Rückprojektion ein Bild gewinnen läßt.

2. Verfahren nach dem Oberbegriff des Anspruches 1, wobei die Bildrekonstruktion mit einer 2D-Fourierrekonstruktion erfolgt und die dynamische Gleichgewichtsmagnetisierung mit Hilfe geschalteter, unmodulierter Gradientenfelder durch nachstehende Folge aufrecht erhalten wird:

(a) Selektive Anregung einer Schicht des Untersuchungsobjektes durch gleichzeitiges Anlegen eines Schichtauswahlgradienten $G_z$ für eine Dauer T und eines Hochfrequenzpulses mit Flip-Winkel $\alpha$ ($0°$ < $\alpha \leq 90°$).

(b) Gleichzeitiges Anlegen eines Auslegegradienten $-G_x$, y-Gradienten (Phasenkodiergradient) $G_y$ und Schichtauswahlgradienten $-G_z$ für die Dauer von ungefähr T/2.

(c) Anlegen eines Auslegegradienten $G_x$ und Auslesen von N Punkten des vom Untersuchungsobjekt ausgesandten Kernresonanzsignales für die Dauer von ungefähr T.

(d) Anlegen eines y-Gradienten (Phasenkodiergradient) $-G_y$ für die Dauer von ungefähr T/2.

(e) $N_y$-malige Wiederholung der Folge (a) bis (d), jedoch mit veränderten Werten des Phasenkodiergradienten und gleichen oder vorzeichenumgekehrten Werten des Auslesegradienten bis $N_y$ Scans aufgenommen sind, aus denen sich durch eine zweidimensionale Fouriertransformation ein Bild mit Ny × N Punkten gewinnen läßt.

3. Verfahren nach dem Oberbegriff des Anspruches 1, wobei die Bildrekonstruktion mit einer 3D-Fourierrekonstruktion erfolgt und die dynamische Gleichgewichtsmagnetisierung mit Hilfe geschalteter, unmodulierter Gradientenfelder durch nachstehende Folge aufrecht erhalten wird:

(a) Selektive Anregung einer Schicht des Untersuchungsobjektes durch gleichzeitiges Anlegen eines Schichtauswahlgradienten $G_z$ für eine Dauer T und eines Hochfrequenzpulses mit Flip-Winkel $\alpha$ ($0°$ < $\alpha \leq 90°$).

(b) Gleichzeitiges Anlegen eines x-Gradienten $-G_x$, y-Gradienten (Phasenkodiergradient) $G_y$ und Schichtauswahlgradienten $-G_z$ für die Dauer von ungefähr T/2.

(c) Anlegen eines x-Gradienten $G_x$ und Auslesen von N Punkten des vom Untersuchungsobjekt ausgesandten Kernresonanzsignales für die Dauer von ungefähr T.

(d) Anlegen eines y-Gradienten (Phasenkodiergradienten) $-G_y$ für die Dauer von ungefähr T/2.

(e) $N_y \times N_z$-malige Wiederholung der Folge (a) bis (d), jedoch mit veränderten Werten des Schichtauswahlgradienten und Phasenkodiergradienten sowie gleichen oder vorzeichenumgekehrten Werten des x-Gradienten bis eine $N_z \times N_y$ Matrix von Scans aufgebaut ist, aus der sich $N_z$ Bilder mit je $N_y \times$ N Punkten mittels einer 3D Fouriertransformation rekonstruieren lassen.

4. Verfahren nach einem der Ansprüche 1 bis 3, wobei der Folgeschritte (e) mit vorzeichenalternierenden Werten des Schichtauswahlgradienten durchgeführt wird.

5. Verfahren nach einem der Ansprüche 1 bis 3, wobei der Folgeschritt (e) mit gleichen Werten des Schichtauswahlgradienten durchgeführt wird.

6. Verfahren nach einem der Ansprüche 1 bis 5, wobei der Folgeschritt (b) mit solch einem Zeitintegral des Projektions- bzw. Auslesegradienten durchgeführt wird, daß im Fourierraum keine in Ausleserichtung verschobenen Echozentren auftreten.

7. Verfahren nach einem der Ansprüche 1 bis 6, wobei im Folgeschritt (d) zusätzlich ein Projektionsbzw. Auslesegradient ($-G_r$, $-G_x$) eingeschaltet wird.

8. Verfahren nach einem der Ansprüche 1 bis 7, wobei im Folgeschritt (d) zusätzlich ein Schichtauswahlgradient ($+G_z$) eingeschaltet wird.

9. Verfahren nach einem der Ansprüche 1 bis 8, wobei im Folgeschritt (e) ein Hochfrequenzpuls mit vorzeichenalterniertem Wert des Flip-Winkels verwendet wird.

10. Verfahren nach einem der Ansprüche 1 bis 8, wobei im Folgeschritt (e) ein Hochfrequenzimpuls mit jeweils gleichem Wert des Flip-Winkels verwendet wird.

## Claims

1. A method for operating a nuclear magnetic resonance apparatus for examining an object (5) with the aid of nuclear magnetic resonance, with coils (1, 2, 3, 4, 7, 8) for applying fundamental and gradient magnetic fields to the examination object (5), and a high frequency device (9, 16) which irradiates the examination object (5) with a series of high frequency pulses and which picks up nuclear resonance signals emitted from the examination object (5), image reconstruction being effected by filtered back-projection and the dynamic equilibrium magnetisation being maintained with the aid of switched unmodulated gradient fields through the following sequence:

a) selective excitation of a slice of the examination object by simultaneously applying a slice selection gradient $G_z$ for a duration T and a high frequency pulse with a flip angle $\alpha$ ($0°$ < $\alpha \leq 90°$).

b) simultaneous application of a projection gradient $-G_r$ and slice selection gradient $-G_z$ for a duration of approximately T/2.

c) application of a projection gradient $G_r$ and reading out the nuclear resonance signal emitted from the examination object for a duration of approximately T.

d) –

e) repeating the sequence (a) to (d) $N_r$ times, but with the directions of the projection gradient changed, until $N_r$ scans are recorded, and from these an image can be obtained by Fourier transformation and filtered back-projection.

2. Method according to the preamble of claim 1, wherein image reconstruction is effected with a 2-D Fourier reconstruction and the dynamic equilibrium magnetisation is maintained with the aid of switched, unmodulated gradient fields through the following sequence:

a) selective excitation of a slice of the examination object by the simultaneous application of a slice selection gradient $G_z$ for a duration T and a high frequency pulse with flip angle $\alpha$ ($0° < \alpha \leq 90°$).

b) simultaneous application of a read-out gradient $-G_x$, y-gradient (phase coding gradient) $G_y$ and slice selection gradient $-G_z$ for duration of approximately T/2.

c) application of a read-out gradient $G_x$ and reading-out N points of the nuclear resonance signal emitted by the examination object for a duration of approximately T.

d) application of a y-gradient (phase coding gradient) $-G_y$ for a duration of approximately T/2.

e) repetition of the sequence (a) to (d) $N_y$ times, but with changed values of the phase coding gradient and with the same or sign-reversed values of the read-out gradient until $N_y$ scans are recorded, from which an image with $N_y \times N$ points can be obtained by two-dimensional Fourier transformation.

3. Method according to the preamble of claim 1, wherein image reconstruction is effected by a 3D-Fourier reconstruction and the dynamic equilibrium magnetisation is maintained with the aid of switched unmodulated gradient fields through the following sequence:

a) selective excitation of a slice of the examination object by the simultaneous application of a slice selection gradient $G_z$ for a duration T and a high frequency pulse with a flip angle $\alpha$ ($0° < \alpha \leq 90°$).

b) simultaneous application of an x-gradient $-G_x$, y-gradient (phase coding gradient) $G_y$ and slice selection gradient $G_z$ for a duration of approximately T/2.

c) application of an x-gradient $G_x$ and reading-out of N points of the nuclear resonance signal emitted by the examination object for a duration of approximately T.

d) application of a y-gradient (phase coding gradient) $-G_y$ for a duration of approximately T/2.

e) repetition of the sequence (a) to (d) $N_y \times N_z$ times, but with changed values of the slice selection gradient and phase coding gradient and with the same or sign-reversed values of the x-gradient, until an $N_z \times N_y$ matrix of scans is built-up, from which $N_z$ images each with $N_y \times N$ points can be reconstructed by means of a 3D Fourier transformation.

4. Method according to one of claims 1 to 3, wherein step (e) is carried out with alternating sign values of the slice selection gradient.

5. Method according to one of claims 1 to 3, wherein step (e) is carried out with the same values of the slice selection gradient.

6. Method according to one of claims 1 to 5, wherein step (b) is carried out with a time integral of the projection or read-out gradient such that no echo centres shifted in the read-out direction occur.

7. Method according to one of claims 1 to 6, wherein in step (d) a projection or read-out gradient ($-G_r$, $-G_z$) is additionally applied.

8. Method according to one of claims 1 to 7, wherein in step (d) a slice selection gradient ($+G_z$) is additionally applied.

9. Method according to one of claims 1 to 8, wherein in step (e) a high frequency pulse with an alternating sign value of the flip angle is used.

10. Method according to one claims 1 to 8, wherein in step (e) a high frequency pulse with respectively the same value of the flip angle is used.

**Revendications**

1. Procédé pour faire fonctionner un appareil à résonance magnétique nucléaire pour examiner un objet (5) à l'aide de la résonance magnétique nucléaire, comportant des bobines (1, 2, 3, 4, 7, 8) servant à appliquer un champ magnétique de base et des champs magnétiques irrotationnels à l'objet à examiner (5), et un dispositif à haute fréquence (9, 16), qui irradie l'objet à examiner (5) avec une suite d'impulsions à haute fréquence et qui détecte les signaux de résonance nucléaire émis par l'objet à examiner (5), la reconstitution de l'image s'effectuant avec une rétroprojection filtrée, et l'aimantation dynamique d'équilibre est maintenue à l'aide de champs irrotationnels non modulés, appliqués, avec les conséquences suivantes:

(a) excitation sélective d'une couche de l'objet à examiner par application simultanée d'un gradient $G_z$ de sélection d'une couche, pendant une durée T, et d'une impulsion à haute fréquence avec un angle de pivotement $\alpha$ ($0° < \alpha \leq 90°$);

(b) application simultanée d'un gradient de projection $-G_r$ et d'un gradient $-G_z$ de sélection d'une couche pendant une durée égale à environ T/2;

(c) application d'un gradient de projection $G_r$ et lecture du signal de résonance nucléaire émis par l'objet à examiner, pendant la durée égale approximativement à T;

(d) –

(e) répétition $N_r$ fois de la séquence (a) à (d), mais avec des directions modifiées du gradient de projection, jusqu'à l'obtention de $N_r$ balayages, à partir desquels on peut obtenir une image au moyen d'une transformation de Fourier et d'une rétroprojection filtrée.

2. Procédé selon le préambule de la revendication 1, dans lequel la reconstitution de l'image est réalisée avec une reconstitution bidimensionnelle de Fourier et l'aimantation dynamique d'équilibre est maintenue à l'aide de champs irrotationnels non modulés, appliqués, avec la séquence suivantes:

(a) excitation sélective d'une couche de l'objet à examiner par application simultanée d'un gradient $G_z$ de sélection d'une couche, pendant une durée T, et d'une impulsion à haute fréquence avec un angle de pivotement $\alpha$ ($0° < \alpha \leq 90°$);

(b) application simultanée d'und gradient de lecture $-G_x$, d'un gradient suivant y (gradient de codage de phase $G_y$) et d'un gradient $-G_z$ de sélection d'une couche, pendant la durée égale approximativement à T/2;

(c) application d'un gradient de lecture $G_r$ et lecture de N points du signal de résonance nucléaire émis par l'objet à examiner, pendant la durée égale approximativement à T;

(d) application d'un gradient suivant y (gradient de codage de phase) $-G_y$ pendant la durée égale approximativement à T/2;

(e) répétition $N_y$ fois de la séquence (a) à (d), mais avec des valeurs modifiées du gradient de codage de phase et des valeurs identiques ou de signe opposé du gradient de lecture jusqu'à l'enregistrement de $N_y$ balayages, à partir desquels on peut obtenir une image comportant $N_y \times N$ points à partir d'une transformation bidimensionnelle de Fourier.

3. Procédé suivant le préambule de la revendication 1, selon lequel la reconstitution de l'image s'effectue à l'aide d'une reconstitution tridimensionnelle de Fourier et l'aimantation dynamique d'équilibre est maintenue à l'aide de champs irrotationnels non modulés, appliqués, avec la séquence suivante:

(a) excitation sélective d'une couche de l'objet à examiner par application simultanée d'un gradient $G_z$ de sélection d'une couche, pendant une durée T, et d'une impulsion à haute fréquence avec un angle de pivotement $\alpha$ ($0° < \alpha \leq 90°$);

(b) application simultanée d'un gradient suivant x $-G_x$, d'un gradient $-y$ (gradient de codage de phase) $G_y$ et d'un gradient $-G_z$ de sélection d'une couche, pendant la durée égale approximativement à T/2;

(c) application suivant x d'un gradient $G_x$ et lecture de N points du signal de résonance nucléaire émis par l'objet à examiner, pendant la durée égale approximativement à T;

(d) application suivant y d'un gradient (gradient de codage de phase) $-G_y$, pendant la durée égale approximativement à T/2;

(e) répétition $N_y \times N_z$ fois de la séquence (a) à (d), mais avec des valeurs modifiées du gradient de sélection de la couche et du gradient de codage de phase ainsi que des valeurs identiques ou de signe inverse du gradient suivant x jusqu'à l'établissement d'une matrice de $N_z \times N_y$ balayages, à partir de laquelle on peut reconstituer $N_z$ images comportant chaque $N_y \times N$ points à l'aide d'une transformation tridimensionnelle de Fourier.

4. Procédé suivant l'une des revendications 1 à 3, selon lequel l'étape (e) de la séquence est exécuté avec des valeurs qui possèdent des signes alternés, du gradient de sélection de la couche.

5. Procédé suivant l'une des revendications 1 à 3, selon lequel l'étape (e) de la séquence est exécuté avec des valeurs identiques du gradient de sélection de la couche.

6. Procédé suivant l'une des revendications 1 à 5, selon lequel l'étape (b) de la séquence est exécuté avec une intégrale dans le temps du gradient de projection ou de lecture, tel qu'il n'apparaît, dans l'espace de Fourier, aucun centre d'écho décalé dans la direction de la lecture.

7. Procédé suivant l'une des revendications 1 à 6, selon lequel lors de l'étape (d) de la séquence, un gradient de projection ou de lecture ($-G_r$, $-G_z$) est appliqué en supplément.

8. Procédé suivant l'une des revendications 1 à 7, selon lequel lors de l'étape (d) de la séquence, un gradient ($+G_z$) de sélection de la couche est appliqué en supplément.

9. Procédé suivant l'une des revendications 1 à 8, selon lequel, lors de l'étape (e) de la séquence, on utilise une impulsion à haute fréquence avec une valeur de l'angle de pivotement à signe alterné.

10. Procédé suivant l'une des revendications 1 à 8, selon lequel, lors de l'étape (e) de la séquence, on utilise une impulsion à haute fréquence avec respectivement la même valeur de l'angle de pivotement.

FIG 1

FIG 2

FIG 3

FIG 4